# FASCICULE DE BREVET EUROPEEN

(11) **EP 3 776 617 B1**
(45) Date de publication et mention de la délivrance du brevet: **17.07.2024**
(21) Numéro de dépôt: 19717526.8
(22) Date de dépôt: 13.03.2019
(51) Int. Cl.: H01H 3/00

(54) **DISPOSITIF ÉLECTRONIQUE DE COUPURE ET PROCÉDÉ DE DÉTECTION DE DÉFAUT**
ELEKTRONISCHE ABSCHALTVORRICHTUNG UND VERFAHREN ZUR FEHLERERKENNUNG
ELECTRONIC CUT-OFF DEVICE AND FAULT DETECTION PROCESS

(30) Priorité: 12.04.2018 FR 1853196
(43) Date de publication de la demande: 17.02.2021
(73) Titulaire: Legrand France, 87000 Limoges (FR); Legrand SNC, 87000 Limoges (FR)
(72) Inventeur: AMPILHAC, Christophe, 87220 FEYTIAT (FR)
(74) Mandataire: Jacobacci Coralis Harle
(86) Numéro de dépôt international: PCT/FR2019/050554
(87) Numéro de publication internationale: WO 2019/197740

(56) Documents cités:
- EP-A1- 2 879 152
- EP-A1- 3 059 112
- US-A1- 2005 254 275

## Description

### DOMAINE TECHNIQUE AUQUEL SE RAPPORTE L'INVENTION

La présente invention concerne de manière générale le domaine des dispositifs électroniques permettant de sélectivement transmettre ou couper l'alimentation électrique d'une charge.

Elle concerne plus particulièrement un interrupteur électrique comprenant une première borne d'entrée, une seconde borne d'entrée, une première borne de sortie, une seconde borne de sortie, un interrupteur commandable interposé entre la première borne d'entrée et la première borne de sortie, et un circuit de commande adapté à produire un signal de commande destiné à l'interrupteur commandable.

### ARRIERE-PLAN TECHNOLOGIQUE

Un tel dispositif électronique permet d'appliquer sélectivement (sur commande du circuit de commande) une tension (appliquée entre les bornes d'entrée) à une charge connectée aux bornes de sortie.

Le circuit de commande peut déterminer le signal de commande à produire (pour entraîner l'ouverture ou la fermeture de l'interrupteur commandable) selon diverses consignes telles qu'une consigne locale (définie par exemple au moyen d'un bouton équipant le dispositif électronique de coupure) et/ou une consigne distante (reçue par exemple via un circuit de communication), ce qui offre une grande souplesse de fonctionnement.

Certains interrupteurs commandables utilisés dans ces dispositifs électroniques peuvent toutefois rester figés en position fermée (typiquement à cause d'une surintensité momentanée provoquée par la charge alimentée et induisant une soudure ou un collage des contacts de l'organe de coupure), même lorsque le circuit de commande leur applique un signal de commande d'ouverture.

Le document EP 2 879 152 décrit un dispositif de coupure d'alimentation à courant alternatif comprenant un relais monté dans une ligne d'alimentation et un dispositif de détection d'un défaut de soudure du relais.

Selon ce document, la détection d'un éventuel défaut de soudure est basée sur la différence de courant induit dans un transformateur enroulé avec la ligne d'alimentation selon que le relais est soudé ou non.

On connaît par ailleurs du document US 2005/254 275 un onduleur capable de détecter un défaut de soudure d'un interrupteur au moyen de mesures de tension.

### OBJET DE L'INVENTION

Dans ce contexte, la présente invention propose un interrupteur électrique conforme à la revendication 1.

Grâce au circuit d'impédance fini interposé entre les bornes de sortie, un courant s'écoule à travers l'interrupteur commandable lorsque celui-ci est en position fermée, même en l'absence de charge connectée aux bornes de sortie. Le circuit de commande peut ainsi détecter grâce au circuit de mesure une fermeture anormale de l'interrupteur commandable (c'est-à-dire une fermeture de l'interrupteur commandable alors que le circuit de commande génère un signal de commande d'ouverture), même en l'absence de charge.

D'autres caractéristiques non limitatives et avantageuses du dispositif électronique de coupure conforme à l'invention, prises individuellement ou selon toutes les combinaisons techniquement possibles, sont les suivantes :
- l'indication de défaut est un allumage d'un indicateur lumineux ;
- l'indication de défaut est une commande d'allumage d'un indicateur lumineux ou une information de défaut transmise à un terminal utilisateur ;
- le dispositif électronique de coupure comprend une interface homme machine conçue pour transmettre une information de commande locale au circuit de commande ;
- le dispositif électronique de coupure comprend un circuit de communication conçu pour transmettre une information de commande distante au circuit de commande ;
   - le circuit de mesure est conçu pour mesurer une intensité d'un courant à travers l'interrupteur commandable, ladite grandeur électrique étant cette intensité ;
   - le circuit d'impédance finie est une résistance montée entre la première borne de sortie et la seconde borne de sortie.

L'invention propose également un procédé de détection de défaut conforme à la revendication 8.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est un schéma électrique d'un système électrique comprenant un interrupteur électrique conforme à l'invention ; et
- la figure 2 est un logigramme illustrant un exemple de procédé mis en oeuvre au sein d'un tel interrupteur électrique.

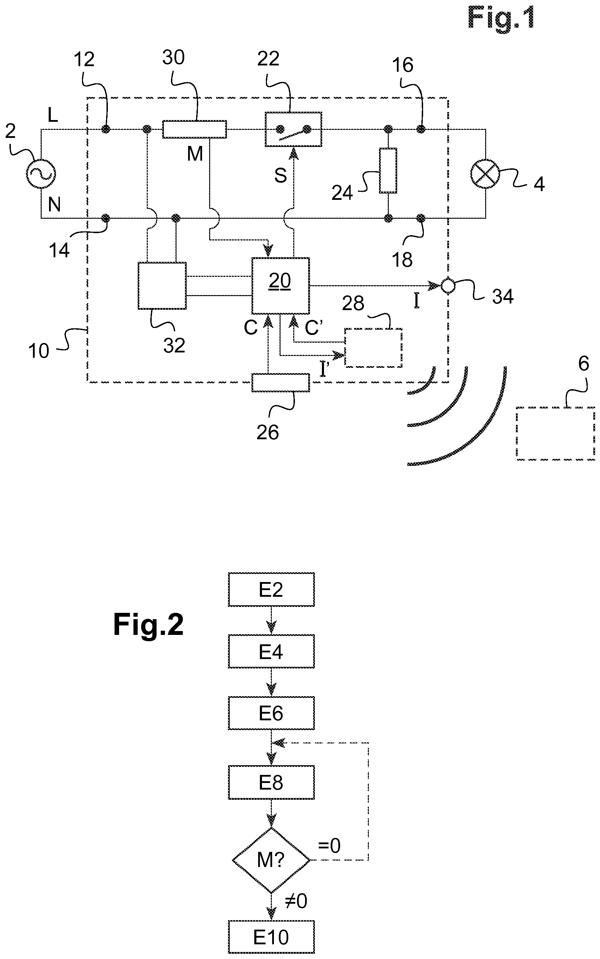

La figure 1 représente un système électrique comprenant une source de tension (ici alternative) 2, une charge 4 et un dispositif électronique de coupure 10 interposé entre la source de tension 2 et la charge 4.

Un tel dispositif électronique de coupure 10 est selon l'invention un interrupteur électrique (c'est-à-dire un appareillage électrique de type interrupteur) à encastrer dans une cloison ou à monter en saillie sur une cloison.

La source de tension 2 est ici typiquement un réseau électrique équipant un bâtiment (par exemple un logement) et appliquant, entre deux bornes d'alimentation L, N, une tension alternative, dite tension secteur, ayant des caractéristiques définies par la règlementation applicable (par exemple une tension efficace nominale de 230 V et une fréquence de 50 Hz). Dans ce contexte, la borne d'alimentation L est la borne de phase, tandis que la borne d'alimentation N est la borne de neutre.

La charge 4 est par exemple une lampe (dont l'allumage ou l'extinction est alors commandée au moyen du dispositif électronique de coupure 10 comme décrit ci-après). D'autres types de charge sont toutefois bien sûr envisageables.

Comme représenté schématiquement par les pointillés sur la figure 1, la présence de la charge 4 n'est en revanche pas systématique : la charge 4 peut être absente dans certains situations (par exemple, lorsque la charge 4 est une lampe, lors d'un remplacement de la charge 4 par l'utilisateur ou, lorsque le dispositif électronique de coupure 10 est selon un mode de réalisation non couvert par l'invention intégré à une prise électrique, lorsqu'aucun appareil électrique n'est branché sur cette prise électrique). Une fois le dispositif électronique de coupure 10 branché sur la source de tension 2 comme représenté en figure 1, le dispositif électronique de coupure 10 doit donc pouvoir fonctionner en présence ou en l'absence de la charge 4.

Le dispositif électronique de coupure 10 comprend une première borne d'entrée 12, une seconde borne d'entrée 14, une première borne de sortie 16 et une seconde borne de sortie 18.

Dans l'exemple décrit ici, la première borne d'entrée 12 est destinée à être branchée sur la borne de phase L de la source de tension 2, tandis que la seconde borne d'entrée 14 est destinée à être branchée sur la borne de neutre N de la source de tension 2.

Comme visible sur la figure 1, le dispositif électronique de coupure 10 comprend un circuit de mesure 30 et un interrupteur commandable 22 montés en série entre la première borne d'entrée 12 et la première borne de sortie 16.

La seconde borne d'entrée 14 et la seconde borne de sortie 18 sont quant à elle reliées électriquement l'une à l'autre, ici directement. Autrement dit, la seconde borne d'entrée 14 et la seconde borne de sortie 18 ont un potentiel électrique identique.

Le circuit de mesure 30 est conçu pour produire une mesure M d'une grandeur électrique consommée à travers l'interrupteur commandable 22. Cette grandeur électrique est ici l'intensité du courant traversant l'interrupteur commandable 22 ; en variante, il pourrait s'agir de la puissance consommée à travers l'interrupteur commandable 22. Le circuit de mesure 30 est par exemple réalisé au moyen d'un shunt.

Le dispositif électronique de coupure 10 comprend également un circuit de commande 20 qui reçoit la mesure M produite par le circuit de mesure 30.

Le circuit de commande 20 commande l'ouverture et éventuellement la fermeture de l'interrupteur commandable 22 au moyen d'un signal de commande S.

Le circuit de commande 20 est par exemple un microcontrôleur. Un tel microcontrôleur comprend typiquement un processeur et au moins une mémoire. Cette mémoire mémorise notamment des instructions de programme d'ordinateur conçues de manière à ce que le microcontrôleur mette en oeuvre les fonctionnalités et les procédés décrits ci-dessous (notamment le procédé décrit ci-dessous en référence à la figure 2) lorsque ces instructions sont exécutées par le processeur.

En variante, le circuit de commande 20 pourrait être un circuit programmé à application spécifique.

Comme schématiquement représenté en figure 1, le circuit de commande 20 est par exemple alimenté par un circuit d'alimentation 32 connecté d'une part à la première borne d'entrée 12 et d'autre part à la seconde borne d'entrée 14, le circuit d'alimentation 32 recevant ainsi la tension générée par la source de tension 2 (c'est-à-dire ici la tension secteur).

Bien que cela ne soit pas représenté en figure 1, le circuit d'alimentation 32 peut éventuellement alimenter en pratique d'autres éléments du dispositif électronique de coupure 10.

Selon un premier mode de réalisation, le circuit de commande 20 reçoit une information de commande C (ou commande locale C) en provenance d'une interface homme-machine 26 équipant le dispositif électronique de coupure 10. L'interface homme-machine 26 est par exemple un bouton, tel qu'un bouton poussoir.

Dans ce cas, le circuit de commande 20 génère un signal de commande S (d'ouverture ou de fermeture de l'interrupteur commandable 22) en fonction notamment de l'information de commande C produite par l'interface homme-machine 26. On peut prévoir par exemple que le signal de commande S bascule entre un état entraînant la fermeture de l'interrupteur commandable 22 et un état entraînant l'ouverture de l'interrupteur commandable 22 à chaque action sur l'interface homme-machine 26 (c'est-à-dire par exemple à chaque pression sur le bouton poussoir 26).

Selon un second mode de réalisation (illustré en pointillés sur la figure 1), éventuellement combinable au premier mode de réalisation, le circuit de commande 20 reçoit une information de commande C' (ou commande distante C') en provenance d'un appareil de commande 6 externe et via un circuit de communication 28 en communication avec l'appareil de commande 6.

Le circuit de communication 28 (qui équipe dans ce cas le dispositif électronique de coupure 10 comme représenté en pointillés en figure 1) peut être en pratique apte à établir une liaison sans fil avec l'appareil de commande 6 et à échanger ainsi des données (notamment l'information de commande C') avec l'appareil de commande 6.

En variante, le circuit de communication 28 pourrait être apte à établir une liaison filaire avec l'appareil de commande 6, éventuellement une liaison filaire utilisant les câbles du réseau électrique mentionné plus haut (grâce par exemple à une technologie de courants porteurs).

On remarque que l'information de commande C' pourrait être en pratique transmise de l'appareil de commande 6 (par exemple dans ce cas un terminal utilisateur tel qu'un ordiphone) au circuit de communication 28 à travers différents réseaux (y compris par exemple un réseau de téléphonie cellulaire et un réseau local filaire ou sans fil).

Le circuit de communication 28 est par ailleurs relié au circuit de commande 20 (par exemple au moyen d'un bus informatique) afin de transmettre au circuit de commande 20 les données (notamment l'information de commande C') reçues par le circuit de communication 28 (en provenance notamment de l'appareil de commande 6).

Le dispositif électronique de coupure 10 comprend également un circuit d'impédance finie 24 monté entre la première borne de sortie 16 et la seconde borne de sortie 18. Ce circuit d'impédance finie 24 est par exemple un dipôle électrique (ici une résistance), dont une borne est ici connectée à la première borne de sortie 16 et l'autre borne est connectée à la seconde borne de sortie 18. Le circuit d'impédance finie 24 a par exemple une résistance comprise entre 100 kΩ et 1 MΩ, ici une résistance de 470 kΩ.

Lorsque le circuit de commande 20 commande l'ouverture de l'interrupteur commandable 22 (par génération d'un signal de commande S d'ouverture), en général à réception d'une information de commande C, C' correspondante, le circuit de commande 20 surveille la mesure M de la grandeur électrique consommée à travers l'interrupteur commandable 22 (mesure M reçue comme déjà indiqué du circuit de mesure 30).

En fonctionnement normal, l'interrupteur commandable 22 est effectivement ouvert par le signal de commande S d'ouverture, et aucun courant ne peut par conséquent s'écouler entre la première borne d'entrée 12 et la première borne de sortie 16. La mesure M produite par le circuit de mesure 30 (et transmise au circuit de commande 20) indique alors une consommation nulle (c'est-à-dire ici une intensité nulle à travers l'interrupteur commandable 22).

Au contraire, si le circuit de mesure 30 produit une mesure M indicative d'une consommation non nulle (ici d'une intensité non nulle à travers l'interrupteur commandable 22), cela signifie qu'un courant s'écoule à travers l'interrupteur commandable 22 malgré le signal de commande S d'ouverture, ce qui indique que l'interrupteur commandable 22 est figé en position fermé (autrement dit : *"collé*")*.*

On remarque que ce courant est présent même en l'absence de la charge 4 grâce à la présence du circuit d'impédance finie 24 monté entre la première borne de sortie 16 et la seconde borne de sortie 18.

Ainsi, si le circuit de commande 20 génère un signal de commande S d'ouverture de l'interrupteur commandable 22 et reçoit une mesure M indicative d'une consommation non-nulle, le circuit de commande 20 génère une indication de défaut I, I', par exemple en émettant une commande d'allumage I d'un indicateur lumineux de défaut 34 (typiquement en pratique une diode électroluminescente visible par l'utilisateur) et/ou une information de défaut I' en direction du circuit de communication 28. Cette information de défaut I' peut alors être transmise par le circuit de communication 28 à un terminal utilisateur (par exemple un ordiphone) de l'utilisateur.

Pour ce faire, un identifiant électronique (par exemple une adresse électronique ou un numéro de téléphone) associé à l'utilisateur est par exemple mémorisé dans le circuit de commande 20 ou le circuit de communication 28 ; à réception de l'information de défaut l' en provenance du circuit de commande 20, le circuit de communication 28 transmet cette information de défaut l' en utilisant l'identifiant électronique mémorisé.

Selon un mode de réalisation envisageable, le circuit de commande 20 peut également surveiller la mesure M de la grandeur électrique consommée à travers l'interrupteur commandable 22 lorsque le circuit de commande 20 génère un signal de commande S de fermeture de l'interrupteur commandable 22.

Dans ce cas, en fonctionnement normal, la consommation électrique est non nulle du fait de la circulation d'un courant à travers l'interrupteur commandable 22 (pour alimentation du circuit d'impédance finie 24 et éventuellement de la charge 4).

De ce fait, si le circuit de commande 20 reçoit une mesure M indicative d'une consommation nulle à travers l'interrupteur commandable 22 alors que le circuit de commande 20 génère un signal de commande S de fermeture de l'interrupteur commandable, ceci indique également un défaut de fonctionnement et le circuit de commande 20 peut alors commander l'allumage d'un indicateur de défaut (éventuellement différent de l'indicateur de défaut 34) et/ou l'envoi d'une information de défaut à un terminal utilisateur via le circuit de communication 28.

La figure 2 représente un exemple de procédé qui peut être mis en oeuvre par le circuit de commande 20 au sein du dispositif électronique de coupure 10.

Ce procédé débute à l'étape E2 au cours de laquelle le circuit de commande 20 transmet à l'interrupteur commandable un signal de commande S de fermeture. L'interrupteur commandable 22 est donc normalement fermé et, si une charge 4 est présente, celle-ci est alimentée à travers l'interrupteur commandable 22.

Le circuit de commande 20 reçoit à l'étape E4 une information de commande C, C' (par exemple du fait d'un appui de l'utilisateur sur le bouton poussoir 26).

En conséquence de la réception de cette information de commande C, C', le circuit de commande 20 fait basculer le signal de commande S et transmet ainsi à l'étape E6 un signal de commande S d'ouverture à l'interrupteur commandable 22.

Pendant que ce signal de commande S d'ouverture est appliqué à l'interrupteur commandable 22, le circuit de commande 20 acquiert à l'étape E8 la mesure M de grandeur électrique consommée à travers l'interrupteur commandable 22, c'est-à-dire ici la mesure d'intensité fournie par le circuit de mesure 30 monté en série avec l'interrupteur commandable 22.

Si la mesure M reçue indique une consommation électrique nulle (ici une intensité nulle), cela indique que l'interrupteur commandable 22 est bien ouvert et que le dispositif électronique de coupure 10 fonctionne normalement. Le procédé peut éventuellement boucler à l'étape E8 pour acquérir une nouvelle mesure M en provenance du circuit de mesure 30 et continuer à surveiller cette mesure M.

Si la mesure M reçue indique une consommation électrique non nulle, cela indique que l'interrupteur commandable 22 est resté en position fermée malgré l'application à cet interrupteur commandable 22 du signal de commande S d'ouverture et le procédé se poursuit dans ce cas à l'étape E10 pour signaler ce défaut à l'utilisateur.

À l'étape E10, le circuit de commande 20 génère une indication de défaut destinée à l'utilisateur, par exemple par émission de la commande d'allumage I de l'indicateur de défaut 34 et/ou par émission d'une information de défaut I' à destination d'un appareil électronique externe (tel qu'un ordiphone de l'utilisateur) au moyen du circuit de communication 28.

## Revendications

1. Interrupteur électrique (10) à interposer entre un réseau électrique (2) équipant un bâtiment et une charge (4) commandée au moyen dudit interrupteur (10), ledit interrupteur électrique (10) étant à encastrer dans une cloison ou à monter en saillie sur une cloison et comprenant une première borne d'entrée (12), une seconde borne d'entrée (14), une première borne de sortie (16), une seconde borne de sortie (18), un interrupteur commandable (22) interposé entre la première borne d'entrée (12) et la première borne de sortie (16), un circuit de commande (20) adapté à produire un signal de commande (S) destiné à l'interrupteur commandable
**caractérisé en ce qu'**il comprend :
- un circuit de mesure (30) d'une grandeur électrique consommée à travers l'interrupteur commandable (22),
- un circuit d'impédance finie (24) interposé entre la première borne de sortie (16) et la seconde borne de sortie (18),
et **en ce que** le circuit de commande (20) est conçu pour produire un signal de commande (S) d'ouverture de l'interrupteur commandable (22), pour surveiller la grandeur électrique mesurée (M) lorsque ce signal de commande (S) d'ouverture est produit et pour générer une indication de défaut (I ; I') si la grandeur électrique mesurée (M) indique une consommation électrique non nulle à travers l'interrupteur commandable (22) lorsque le signal de commande (S) d'ouverture est produit.

2. Interrupteur électrique selon la revendication 1, dans lequel l'indication de défaut est une commande d'allumage (I) d'un indicateur lumineux (34).

3. Interrupteur électrique selon la revendication 1, dans lequel l'indication de défaut est une information de défaut (I') transmise à un terminal utilisateur.

4. Interrupteur électrique selon l'une des revendications 1 à 3, comprenant une interface homme machine (26) conçue pour transmettre une information de commande locale (C) au circuit de commande (20).

5. Interrupteur électrique selon l'une des revendications 1 à 4, comprenant un circuit de communication (28) conçu pour transmettre une information de commande distante (C') au circuit de commande (20).

6. Interrupteur électrique selon l'une des revendications 1 à 5, dans lequel le circuit de mesure (30) est conçu pour mesurer une intensité d'un courant à travers l'interrupteur commandable (22), ladite grandeur électrique étant cette intensité.

7. Interrupteur électrique selon l'une des revendications 1 à 6, dans lequel le circuit d'impédance finie est une résistance (24) montée entre la première borne de sortie (16) et la seconde borne de sortie (18).

8. Procédé de détection de défaut dans un interrupteur électrique (10) selon la revendication 1, ledit interrupteur étant interposé entre un réseau électrique (2) équipant un bâtiment et une charge (4) commandée au moyen dudit interrupteur (10), et ledit interrupteur électrique (10) étant encastré dans une cloison ou monté en saillie sur une cloison, **caractérisé en ce que** le procédé comprend les étapes suivantes :
- mesure d'une grandeur électrique consommée à travers l'interrupteur commandable (22) ;
- production (E6), par le circuit de commande (20), d'un signal de commande (S) d'ouverture de l'interrupteur commandable (22) ;
- surveillance (E8) de la grandeur électrique mesurée (M) lorsque le signal de commande (S) d'ouverture est produit ; et
- génération (E10) d'une indication de défaut (I ; I') si la grandeur électrique mesurée (M) indique une consommation électrique non nulle à travers l'interrupteur commandable (22) lorsque le signal de commande (S) d'ouverture est produit.

## Patentansprüche

1. Elektrischer Schalter (10), der zwischen einem elektrischen Netz (2) in einem Gebäude und einer mittels des Schalters (10) gesteuerten Last (4) einzusetzen ist, wobei der elektrische Schalter (10) unter Putz in einer Wand oder auf Putz auf einer Wand zu installieren ist und eine erste Eingangsklemme (12), eine zweite Eingangsklemme (14), eine erste Ausgangsklemme (16), eine zweite Ausgangsklemme (18), einen zwischen der ersten Eingangsklemme (12) und der ersten Ausgangsklemme (16) zwischengeschalteten steuerbaren Schalter (22), eine Steuerschaltung (20), die dazu ausgelegt ist, ein für den steuerbaren Schalter bestimmtes Steuersignal (S) zu erzeugen, aufweist,
**dadurch gekennzeichnet, daß** er
- eine Schaltung (30) zum Messen einer durch den steuerbaren Schalter (22) hindurch verbrauchten elektrischen Größe,
- eine zwischen der ersten Ausgangsklemme (16) und der zweiten Ausgangsklemme (18) zwischengeschaltete Schaltung (24) mit endlicher Impedanz
aufweist
und daß die Steuerschaltung (20) dazu ausgelegt ist, ein Steuersignal (S) zum Öffnen des steuerbaren Schalters (22) zu erzeugen, die gemessene elektrische Größe (M) zu überwachen, wenn das Steuersignal (S) zum Öffnen erzeugt worden ist, und eine Fehlermeldung (I; I`) zu erzeugen, wenn die gemessene elektrische Größe (M) einen von Null verschiedenen elektrischen Verbrauch durch den steuerbaren Schalter (22) hindurch anzeigt, wenn das Steuersignal (S) zum Öffnen erzeugt worden ist.

2. Elektrischer Schalter gemäß Anspruch 1, bei dem die Fehlermeldung ein Befehl zum Einschalten (I) einer Leuchtanzeige (34) ist.

3. Elektrischer Schalter gemäß Anspruch 1, bei dem die Fehlermeldung eine an eine Nutzerendstelle übermittelte Fehlermeldung (I') ist.

4. Elektrischer Schalter gemäß einem der Ansprüche 1 bis 3 mit einer Mensch-Maschine-Schnittstelle (26), die dazu ausgelegt ist, eine Information eines lokalen Befehls (C) an die Steuerschaltung (20) zu übermitteln.

5. Elektrischer Schalter gemäß einem der Ansprüche 1 bis 4 mit einer Kommunikationsschaltung (28), die dazu ausgelegt ist, eine Information eines Fembefehls (C') an die Steuerschaltung (20) zu übermitteln.

6. Elektrischer Schalter gemäß einem der Ansprüche 1 bis 5, bei dem die Meßschaltung (30) dazu ausgelegt ist, eine Stärke eines durch den steuerbaren Schalter (22) fließenden Stroms zu messen, wobei die elektrische Größe diese Stromstärke ist.

7. Elektrischer Schalter gemäß einem der Ansprüche 1 bis 7, bei dem die Schaltung mit endlicher Impedanz ein Widerstand (24) ist, der zwischen der ersten Ausgangsklemme (16) und der zweiten Ausgangsklemme (18) eingesetzt ist.

8. Verfahren zum Erfassen eines Fehlers in einem elektrischen Schalter (10) gemäß Anspruch 1, wobei der Schalter zwischen einem elektrischen Netz (2) in einem Gebäude und einer mittels des Schalters (10) gesteuerten Last (4) eingesetzt ist und wobei der elektrische Schalter (10) unter Putz in einer Wand oder auf Putz auf einer Wand installiert ist,
**dadurch gekennzeichnet, daß** das Verfahren die folgenden Schritte aufweist:
- Messen einer durch den steuerbaren Schalter (22) hindurch verbrauchten elektrischen Größe,
- Erzeugen (E6), durch die Steuerschaltung (20), eines Steuersignals (S) zum Öffnen des steuerbaren Schalters (22),
- Überwachen (E8) der gemessenen elektrischen Größe (M), wenn das Steuersignal (S) zum Öffnen erzeugt worden ist, und
- Erzeugen (E10) einer Fehlermeldung (I; I') zu erzeugen, wenn die gemessene elektrische Größe (M) einen von Null verschiedenen elektrischen Verbrauch durch den steuerbaren Schalter (22) hindurch anzeigt, wenn das Steuersignal (S) zum Öffnen erzeugt worden ist.

## Claims

1. An electrical switch (10) to be interposed between an electricity network (2) equipping a building and a load (4) controlled by means of said switch (10), said electrical switch (10) being for being embedded in a partition or for mounting protruding on a partition and comprising a first inlet terminal (12), a second inlet terminal (14), a first outlet terminal (16), a second outlet terminal (18), a controllable switch (22) that is interposed between the first inlet terminal (12) and the first outlet terminal (16), and a control circuit (20) that is adapted to produce a control signal (S) for the controllable switch (22);
**characterized in that** it comprises:
· a measurement circuit (30) for measuring a magnitude of the electricity consumed through the controllable switch (22)
· a finite-impedance circuit (24) that is interposed between the first outlet terminal (16) and the second outlet terminal (18)
and **in that** the control circuit (20) is designed to produce an opening control signal (S) for opening the controllable switch (22), to monitor the measured electrical magnitude (M) when the opening control signal (S) is produced, and to generate a fault indication (I; I') if the measured electrical magnitude (M) indicates non-zero electricity consumption through the controllable switch (22) when the opening control signal (S) is produced.

2. The electrical switch according to claim 1, wherein the fault indication is a lighting command (I) for switching on an indicator lamp (34).

3. The electrical switch according to claim 1, wherein the fault indication is fault information (I') transmitted to a user terminal.

4. The electrical switch according to any one of claims 1 to 3, including a human-machine interface (26) that is designed to transmit local control information (C) to the control circuit (20).

5. The electrical switch according to any one of claims 1 to 4, including a communications circuit (28) that is designed to transmit remote control information (C') to the control circuit (20).

6. The electrical switch according to any one of claims 1 to 5, wherein the measurement circuit (30) is designed to measure electric current passing through the controllable switch (22), said electrical magnitude being said current.

7. The electrical switch according to any one of claims 1 to 6, wherein the finite-impedance circuit is a resistor (24) that is connected between the first outlet terminal (16) and the second outlet terminal (18).

8. Method for detecting a fault in an electrical switch (10) according to claim 1, said switch being interposed between an electricity network (2) equipping a building and a load (4) controlled by means of said switch (10), and said electrical switch (10) being embedded in a partition or mounted protruding on a partition, **characterised in that** the method comprises the following steps:
· measuring a magnitude of the electricity consumed through the controllable switch (22);
· the control circuit (20) producing (E6) an opening control signal (S) for opening the controllable switch (22)
· monitoring (E8) the measured electrical magnitude (M) when the opening control circuit (S) is produced; and
· generating (E10) a fault indication (I; I') if the measured electrical magnitude (M) indicates non-zero electricity consumption through the controllable switch (22) when the opening control signal (S) is produced.
